(19) Europäisches Patentamt / European Patent Office / Office européen des brevets

(11) **EP 3 677 917 B1**

(12) **EUROPEAN PATENT SPECIFICATION**

(45) Date of publication and mention
of the grant of the patent:
**29.11.2023 Bulletin 2023/48**

(21) Application number: **19219744.0**

(22) Date of filing: **27.12.2019**

(51) International Patent Classification (IPC):
*G01N 1/31* *(2006.01)*    *G01N 35/10* *(2006.01)*
*G01N 35/00* *(2006.01)*

(52) Cooperative Patent Classification (CPC):
**G01N 1/312; G01N 35/00722; G01N 35/1016;
G01N 35/109;** G01N 2001/317; G01N 2035/00138;
G01N 2035/00891; G01N 2035/1041

(54) **DIGITAL DISPENSE SYSTEM AND METHOD OF DISPENSING**

DIGITALES DISPENDIERSYSTEM UND VERFAHREN ZUR DOSIERUNG

SYSTÈME DE DISTRIBUTION NUMÉRIQUE ET MÉTHODE DE DISTRIBUTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.01.2019 US 201962788290 P
30.05.2019 US 201916426137**

(43) Date of publication of application:
**08.07.2020 Bulletin 2020/28**

(73) Proprietor: **Funai Electric Co., Ltd.
Daito,
Osaka, 574-0013 (JP)**

(72) Inventors:
• **DEBOARD, Bruce A.
Lexington, KY 40508 (US)**
• **MARRA III, Michael A.
Lexington, KY 40508 (US)**
• **SHARMA, Pramod K.
Lexington, KY 40508 (US)**

(74) Representative: **Becker Kurig & Partner
Patentanwälte mbB
Bavariastraße 7
80336 München (DE)**

(56) References cited:
**CN-A- 102 316 988       JP-A- 2009 517 684
US-A1- 2003 026 737     US-A1- 2006 153 621
US-B2- 7 909 424**

## Description

### RELATED APPLICATION

This application claims priority to provisional application serial No. 62/788,290, filed January 4, 2019, now pending.

### TECHNICAL FIELD

The disclosure is directed to analytical instruments and in particular to instruments that are used to dispense fluids for analytical purposes.

### BACKGROUND AND SUMMARY

In the medical field, in particular, there is a need for automated sample preparation and analysis. The analysis may be colorimetric analysis or require the staining of samples to better observe the samples under a microscope. Such analysis may include drug sample analysis, blood sample analysis and the like. In the analysis of blood, for example, blood is analyzed to provide a number of different factors that are used to determine the health of an individual. When there are a large number of patients that require blood sample analysis, the procedures may be extremely time consuming. Also, there is a need for accurate preparation of the samples so that the results can be relied on. There are many other situations that require sample analysis in the medical field and in other fields that can benefit from the use of analytical instruments that provide accurate and reproduceable results, such as micro-titration of multiple samples.
US 7 909 424 B2 discloses a method and an apparatus for dispensing liquid. The method includes the steps of storing one or more liquids in a thermal inkjet print head and providing a well plate having at least one well. At least one of the liquids is dispensed from the thermal inkjet print head into at least one well. The volume of the dispensed liquid is a fraction of the total required volume of the liquid in the at least one well, and the dispensing step is performed multiple times to dispense the required volume of the at least one liquid in at least one well.

Well plates, slides and other substrates are used for many experiments and laboratory procedures. The process of filling the wells or spotting is often performed manually or using expensive lab equipment. In some cases, the wells are filled with hand operated pipettes. In other cased, high-end automated devices based on pipette technology are used to fill the well plates. Such automated devices accommodate an open well dispense head only. The open well dispense head is a dispense head where a small amount of fluid must be deposited into an opening in the dispense head before use. The fluid is typically deposited manually using a pipette or similar means. The dispense head is held stationary while moving the microplate in both X and Y directions. These high end devices are extremely expensive. Accordingly, there is a need for a digital dispense system that can be used in a wide variety of analytical situations for analysis and digital titration of samples that is much less expensive to purchase. There is also a need for readily visualizing the volume of fluid in each well of a well tray or the amount of fluid that is applied to a predetermined area of a slide.

In view of the foregoing, an embodiment of the disclosure provides a digital dispense system and method for preparing and analyzing samples. The system includes a fluid droplet ejection system housed in a compact housing unit. The fluid droplet ejection system contains a fluid droplet ejection head and fluid cartridge containing one or more fluids to be dispensed, a cartridge translation mechanism for moving the fluid droplet ejection head and fluid cartridge back and forth over a sample holder in an x direction; and a sample holder translation mechanism for moving a sample back and forth beneath the fluid droplet ejection head and fluid cartridge in a y direction orthogonal to the x direction. A digital display device is attached to the fluid droplet ejection system for displaying fluid volume information to a user. The fluid volume information is selected from relative fluid volume, absolute fluid volume, and a combination of relative and absolute fluid volumes.
The relative fluid volume is used to provide a relative volume display that uses one fluid with the highest volume as a maximum and scales the rest of the fluids to the fluid with the highest volume. The absolute fluid volume represents an absolute dispensed fluid volume of the one or more fluids. The digital display device comprises a relative volume graphic for each fluid dispensed to a well in a well plate or to a slide location on a slide

In another embodiment there is provided a method for staining slides without dipping or immersing slides in a dye. The method includes providing a digital fluid droplet ejection system housed in a compact housing unit. The fluid droplet ejection system contains a fluid droplet ejection head and fluid cartridge containing one or more fluids to be dispensed, a cartridge translation mechanism for moving the fluid droplet ejection head and fluid cartridge back and forth over a slide holder in an x direction, and a slide holder translation mechanism for moving one or more slides back and forth beneath the fluid droplet ejection head and fluid cartridge in a y direction orthogonal to the x direction. A digital display device is attached to the digital fluid droplet ejection system. Fluid is ejected from the fluid droplet ejection head and fluid cartridge in one or more locations on the slide. Fluid volume information is displayed to a user on the digital display device. The fluid volume information is selected from relative fluid volume, absolute fluid volume, and a combination of relative and absolute fluid volumes.

The relative fluid volume is used to provide a relative volume display that uses one fluid with the highest volume as a maximum and scales the rest of the fluids to the fluid with the highest volume. The absolute fluid volume represents an absolute dispensed fluid volume of the one or more fluids. The digital display device comprises a relative volume graphic for each fluid dispensed to a well in a well plate or to a slide location on a slide.

In some embodiments, the fluid volume information is displayed by a bar graph representation of fluid in a particular location on a slide or fluid in a well of a well plate. In other embodiments, the digital display has both an absolute volume graphic of fluid dispensed and a relative volume graphic for each fluid dispensed to a well in a well plate or to a slide location on a slide.

In some embodiments, the fluid droplet ejection system further comprises a processor and a memory for storing fluid droplet information and for transferring the fluid droplet information to the digital display device. In other embodiments, the digital display devices is a portable or laptop computer.

In some embodiments, two or more fluids are ejected on a slide simultaneously. In other embodiments two or more fluids are ejected on a slide sequentially.

In digital dispense procedures as described herein, it may be necessary to provide a user of the digital dispense system with an indication of how much of each fluid is applied to specific locations on a slide or deposited in each well of a well plate. In other situations, it may be necessary for the user to know the relative volume of each fluid that is dispensed to a slide or well plate. While only a small number of slides may be processed at one time in the digital dispense system, each well plate may have 96, 384, or 1536 wells or may have a customized number of wells depending on the application and analysis to be performed. Accordingly, a user interface for the digital dispense system would be useful so that the user can readily see if the appropriate amounts of fluids are being dispensed. Thus, an embodiment of the disclosure provides a suitable user interface in combination with the digital dispense system described herein.

## BRIEF DESCRIPTION OF THE DRAWINGS

FIG. 1 is a perspective view, not to scale, of a digital dispense system and display device therefor according to an embodiment of the disclosure.
FIG. 2 is an elevational view, not to scale, of a back side of the digital dispense system of FIG. 1.
FIG. 3 is a perspective cutaway view, not to scale, of the digital dispense system of FIG. 1.
FIG. 4 is a perspective view, not to scale, of a tray for holding samples for use with the digital dispense system of FIG. 1.
FIG. 5 is a perspective view, not to scale, of adapters for slides and well plates for use with the tray of FIG. 4.
FIG. 6 is a perspective view, not to scale, of the tray of FIG. 4 holding a well plate adapter and well plate for the dispense system of FIG. 1.
FIG. 7 is a perspective view, not to scale, of the tray of FIG. 4 holding a slide adapter and slides for the dispense system of FIG. 1.
FIG. 8 is an illustration of dimensions involved in dispensing fluid onto a slide or into a well plate using the dispense system of the disclosure.
FIG. 9 is an illustration of a hypothetical elliptical 4 pass example of the amount of fluid ejected in four passes of the fluid droplet ejection cartridge over a sample.
FIGs. 10A-12B are photomicrographs of slide samples dyed with fluids ejected from the digital dispense system according to an embodiment of the disclosure.
FIGs. 13-15 are illustrations of digital display outputs for volumes of fluids dispensed using the digital dispense device according to the disclosure.

## DETAILED DESCRIPTION OF EXEMPLARY EMBODIMENTS

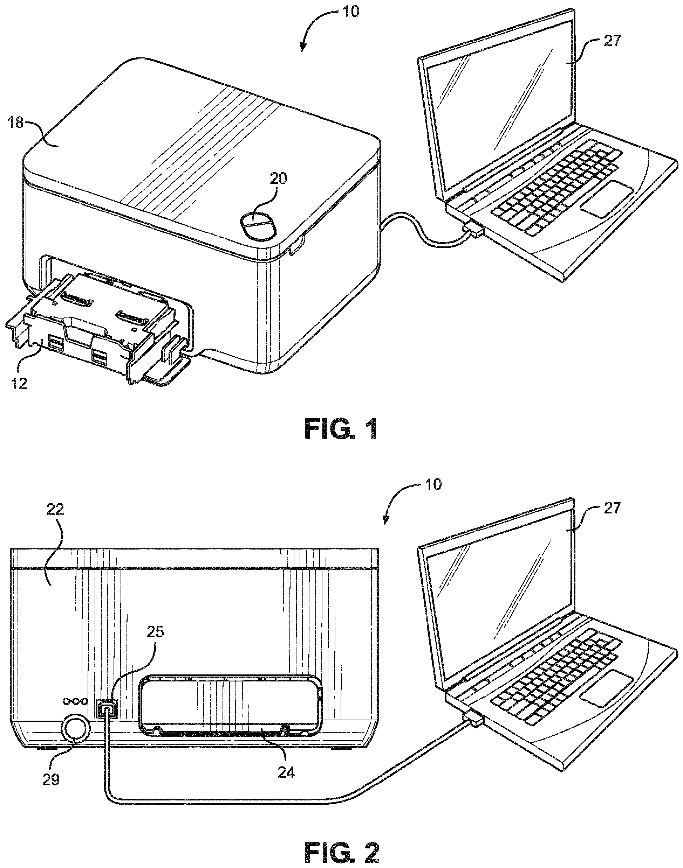

With reference to FIGs. 1-9 there is shown a digital dispense device 10 for accurately dispensing an amount of one or more fluids into the wells of a well plate, or in some defined pattern of spots on a slide (commonly referred to as spotting). Unlike the high-end digital dispense devices, the device 10 of the present invention is based on an ejection head and fluid cartridge 14 that moves back and forth in a first direction and a tray 12 containing the wells or slides that moves back and forth in a second direction orthogonal to the first direction, as described in more detail below. The disclosed device 10 can accept open and closed dispense heads rather than just open dispense head. The tray 12 is adaptable to both standard micro-well plates as well as glass slides and other substances. The ejection head on the ejection head and fluid cartridge 14 may be selected from a wide variety of ejection head devices including, but not limited to, thermal jet ejection heads, bubble jet ejection heads, piezoelectric ejection heads, and the like.

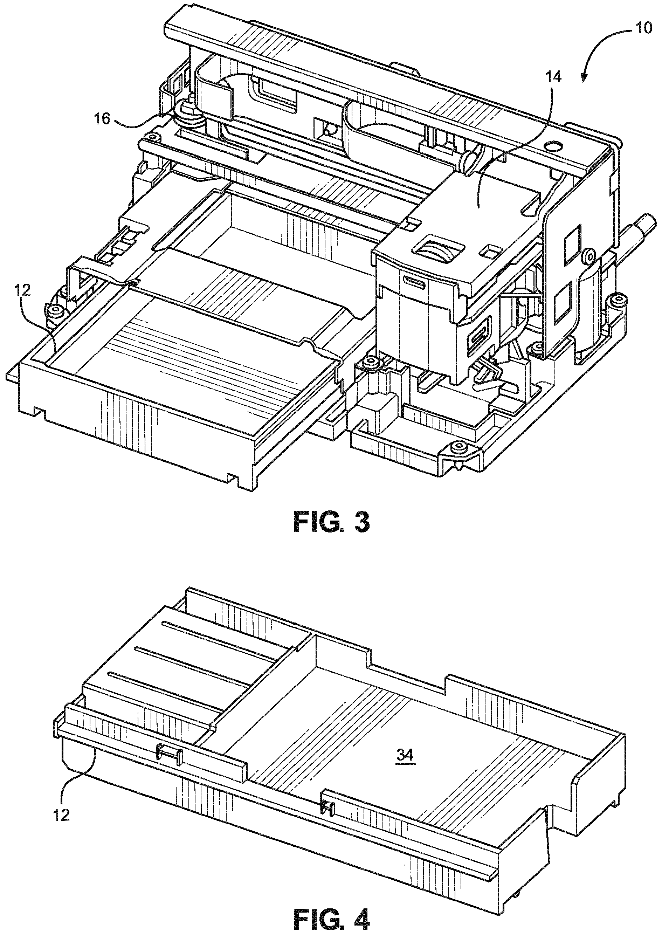

The ejection head and fluid cartridge 14 and head movement mechanism 16 (FIG. 3) are contained in a rectangular prism-shaped box 18. An activation switch 20 is included on the box 18 for activating the device 10. A rear side 22 of the box 18 includes an opening 24 for movement of the tray 12 through the box 18 in the second direction to dispense fluid to the well plate or slides. A USB port 25 is provided on the rear side 22 of the box 18 to connect the digital dispense device 10 to a digital display device 27. Power is provided to the device 10 through a power input port 29 on the rear side 22 of the box 18. In other embodiments, information from the digital dispense device 10 may be transmitted wirelessly to the digital display device 27.

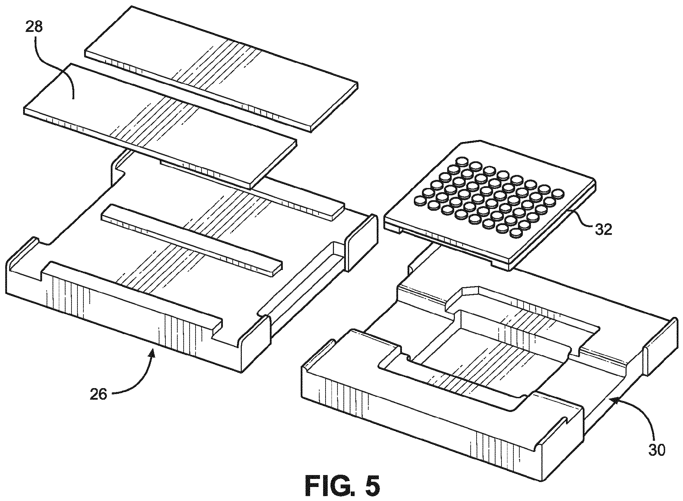

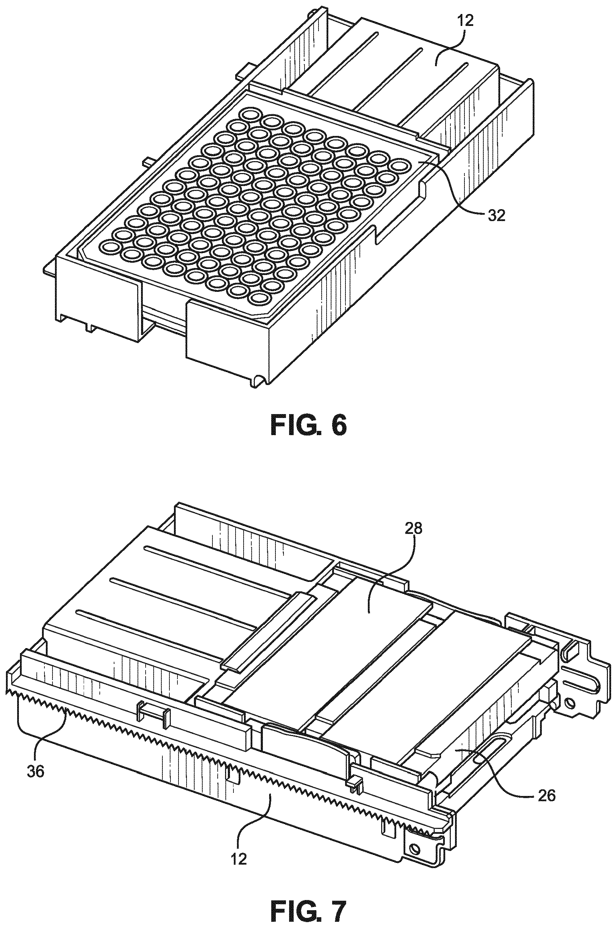

The tray 12 and adapters 26 and 30 for the tray are illustrated in FIGs. 4 and 5. The adapter 26 is sized to hold glass slides 28 and the well plate adapter 30 is sized to hold a micro-well plate 32. The tray 12 has an adapter holder 34 for holding the adapters 26 and 30 for dispensing fluids thereon. FIG.6 illustrates a well plate on the adapter 30 in the tray 12. FIG. 7 illustrates slides 28 on the slide adapter 26 in the tray 12. As shown in FIG. 7, the tray 12 may include gear teeth 36 for indexing the tray 12 in the second direction as the tray moves through the box 18.

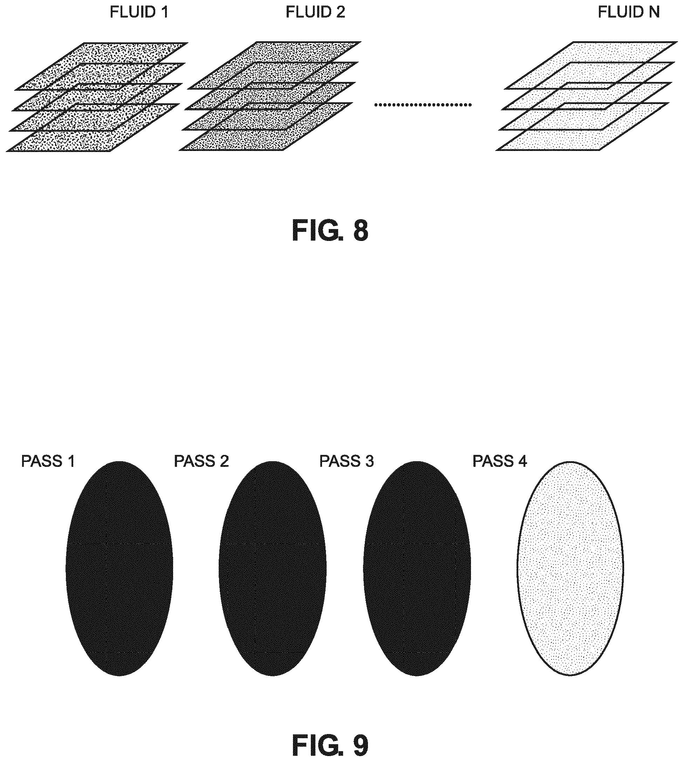

FIGS. 8-9 illustrate methods for calculating an optimized print pattern for dispensing fluid into a microplate, glass slide or other substrate. The method formats data for a digital dispense system 10 where the input is a volume of fluid to be delivered over a defined area.

For a given volume, the number of drops required to dispense that volume of fluid is defined as (volume/drop size).

For example, if a drop size is selected as 10 pico-liters, and it is required to dispense 10 micro-liters, then the ejection head and fluid cartridge 14 will have to dispense $10/10^{e-6}$ or 1,000,000 drops. Now that the number of drops is determined for the given volume, the area can be calculated. Most inkjet printers print on a grid that has a specific resolution, for example (600/2.54)H x (1200/2.54)V (drops per cm). If the target area is a square that is 0.5x2.54 cm per 0.5x2.54 cm, then the maximum number of drops that can be dispensed in that area with one pass of the ejection head and fluid cartridge 14 can be calculated as follows:

$$\text{Area} \ \langle \ [ \ = 0.5^2 \text{x} 2.54^2 \ \text{cm}^2 \ ] \ \rangle$$

$$\text{Maximum drops in one pass} = \text{Area} \ \langle \ [ \ \text{x} \ (600/2.54)\text{x}(1200/2.54) \ ] \ \rangle$$

$$\cancel{* (600 \times 1200)} \quad = 180,000 \text{ drops}.$$

Finally, the total number of passes required to spread this volume over the selected area can be calculated as follows:

$$1,000,000/180,000 = 5.56 \text{ passes}.$$

Accordingly, the ejection head and fluid cartridge 14 will need to make 5 full passes, and then a 'remainder' pass that is not entirely full to dispense the volume of fluid calculated over a given area. Each of the passes will spread the drops consistently over the area.

The input data that is created by the foregoing calculations is effectively an image representing both X and Y axes, but also introducing a Z axis that represents volume as show schematically in FIG. 8. In addition, when dispensing more than 1 channel or fluid at once, a 4th dimension is introduced to track the different channels or fluids.

The foregoing assumes an ejection head on the ejection head and fluid cartridge 14 has a length of 0.5×2.54 cm and can cover the entire area. This is not always be the case, so an additional variable must be introduced, which is the length of the ejection head. For example, if we continue the example from above, but assume that ejection head has a length of 0.25x2.54 cm, this introduces a requirement to move either the ejection head and fluid cartridge 14 over the slide or well plate in the Y direction to fill in the area correctly. Furthermore, there may be reasons in certain applications to increase the number of passes beyond what is the minimum required. Some examples could include:

- To improve some aspect of the output (coverage, uniformity, etc.)
- To artificially limit the maximum volume per pass for experimental reasons.

Variations may be achieved by setting an artificial minimum number of passes for the job. This becomes a multiplier to be used with the required number of passes. So, if the minimum number of passes of 2, then a 50% maximum limit can be set on the number of drops in each pass, which will multiply the total number of passes by 2 overall.

The foregoing method provides benefits over traditional digital dispense systems which may print the entire volume of fluid into a micro-plate well in a single operation. The foregoing method spreads the volume of fluid to be dispensed over multiple dispense head passes and multiple fluid ejectors along a dispense head array of an ejection head. This will minimize the impact of missing or poorly performing fluid ejectors. Depending on the desired dispense accuracy and probability of ejectors not functioning correctly, a minimum number of fluid ejectors to use can be specified or calculated.

In fields such as hematology it may be desirable to deposit or print multiple stains or buffers over a defined area of a substrate such as a glass slide. When printing layers of fluid, the test may be improved by controlling the rate at which the fluid is deposited. This method will allow the user to better control the deposition rate. FIG. 9 illustrates a hypothetical 4 pass example with a "remainder" fourth pass showing that the first three passes have the same drop count, but the fourth pass has a lower drop count as indicated by the lighter color. The fourth pass finishes the remaining number of drops required.

Accordingly, the dispense device according to the invention enables a volume of fluid to be spread consistently over an area/shape that is specified. It also enables a mode to be defined that minimizes variations by distributing ejector head nozzle usage over the entire ejection head. A minimum number of passes of the ejection head and fluid cartridge 14 can be specified along with a maximum volume per pass. If the maximum volume per pass exceeds a defined flow rate, additional passes can be added to the operation mode. The dispense system 10 can be scaled to any number of fluids dispensed by the system.

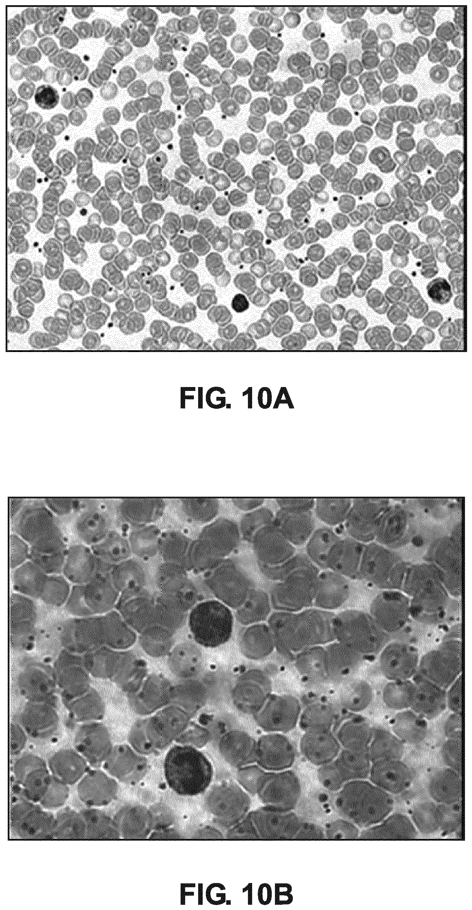

FIGs. 10A-12B illustrate the use of the dispense system 10 to dispense one or more fluids on glass slides to analyze body fluids such as blood. The glass slides 10A and 10B with bloods smears are stained with multiple stains and other fluid types selectively or simultaneously using the digital dispense system 10 according to the disclosure in order to create stained slides for studying cells types in blood samples. The use of stains to identify the blood cells has been used for a long time, but the technique for putting stains on slides is very tedious.

Romanowsky type stains have been used to identify red blood cell (RBC) and white blood cell (WBC) from blood smears on glass slides. Most laboratories use some form of Romanowsky type stain (e.g. Wright-Giemsa). These stains give excellent results but the method to put the stains on slides is cumbersome. In the conventional method, the slides with blood smears are dipped in stains for a period of time. However, dipping slides is labor and time intensive. As described above, the present invention provides an improved technique for creating stained slides for studying cell types in blood samples by depositing precise amounts of fluids in defined locations on the slides.

Multiple types of stains and a buffer solution may be placed in chambers of an ejection head and fluid cartridge 14. Stains such as Giemsa stain for May Grunwald and Giemsa stain or any other type of stain and the buffer solution can then be jetted simultaneously or selectively onto the glass slides. The dispense system 10 provides the flexibility of either jetting one, two or more stains and buffer solutions simultaneously or selectively. In some embodiments, there are three or more fluid chambers and fluid types that are ejected from each ejection head and fluid cartridge 14. The amount of stains used by this method is much less compared to the dipping technique. The use of this technique is not limited to Giemsa and May Grunwald stains. It can be used with any other fluid that meets the requirements of fluid ejection technology. A predetermined volume of each fluid can be jetted with this invention. The dispense technique has been successful in identifying white and red blood cells from stained glass slides with blood smears as shown in FIGs. 10A and 10B.

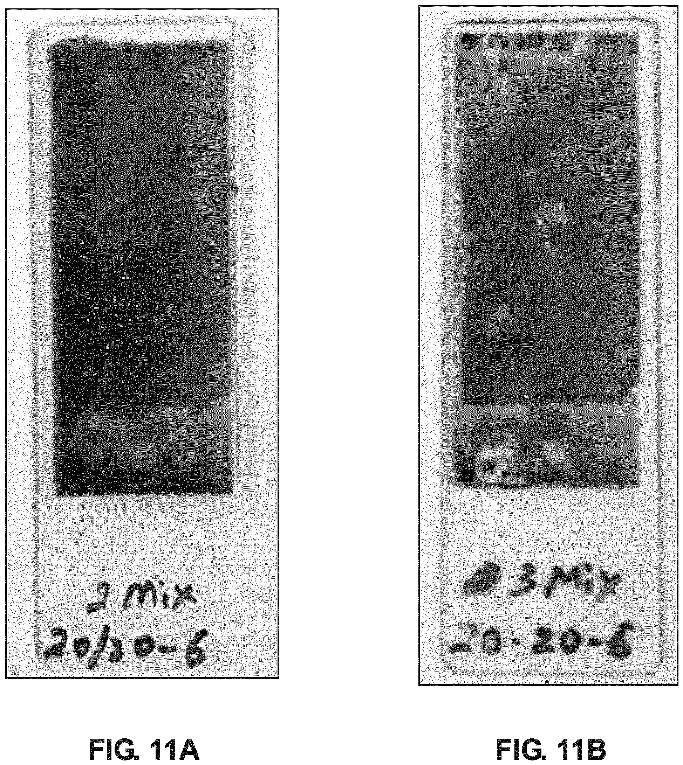

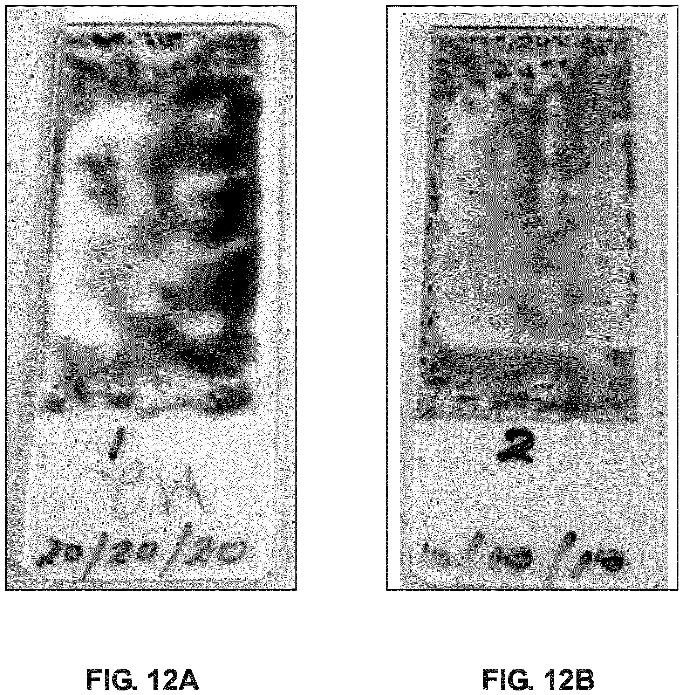

FIGs. 11A and 11B illustrate slides wherein two or three fluid types are simultaneously jetted onto the slides to improve the uniformity of the stained slides. FIGs. 12A and 12B illustrate a technique of selectively staining slides in a sequential manner using the dispense system 10 of the disclosure.

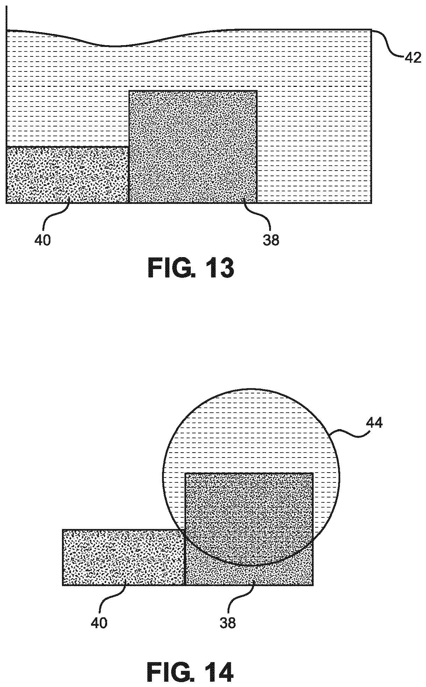

With reference to FIGS. 13-15, there are illustrated a visual representations of fluid volumes dispensed by the digital dispense system 10 and that are displayed on the digital display device 27 to provide a user interface with the digital dispense device 10. The user interface may give a user clear knowledge of the volume in each well of the micro well plate or spot of fluid on a glass slide as well as provide a means to select how much fluid is dispensed in each location of a slide 28 or well plate 32.

When dispensing fluids in applications where volume is an important input, such as medical well plates or slides, it's important to be able to display to the user a useful visual representation of the volume of each fluid being used. Since some wells can hold a significant volume, a relative volume display that uses the fluid with the highest volume as a maximum and scales the rest of the fluids to the highest volume fluid is one way to compare the fluids to each other. An absolute volume scale may not be useful for fluids in a large well since the amount of fluid may not be sufficient to provide visually useful information.

In FIG. 13, bar graphs 38 and 40 for two fluids represent a relative volumes of each fluid on a slide 28 or in a single well of a well plate 32, while 42 represents the absolute total volume of the fluids dispensed. In FIG. 14, bar graphs 38 and 40 of two fluids again represent the relative volumes of each fluid on a slide or in a single well of a well plate 32, however, an expanding circle 44 may be used to represent the total relative volume of all fluids that are dispensed into a well or onto a slide 28. The user interface for display on a digital display device 27 may be configured to provide both types of visual representation shown in FIGS. 13 and 14 by selecting a desired visual representation from a drop down menu in the user interface. Likewise, the user interface may be configured to show the absolute or relative volumes in a single well or in multiple wells of a well plate 32.

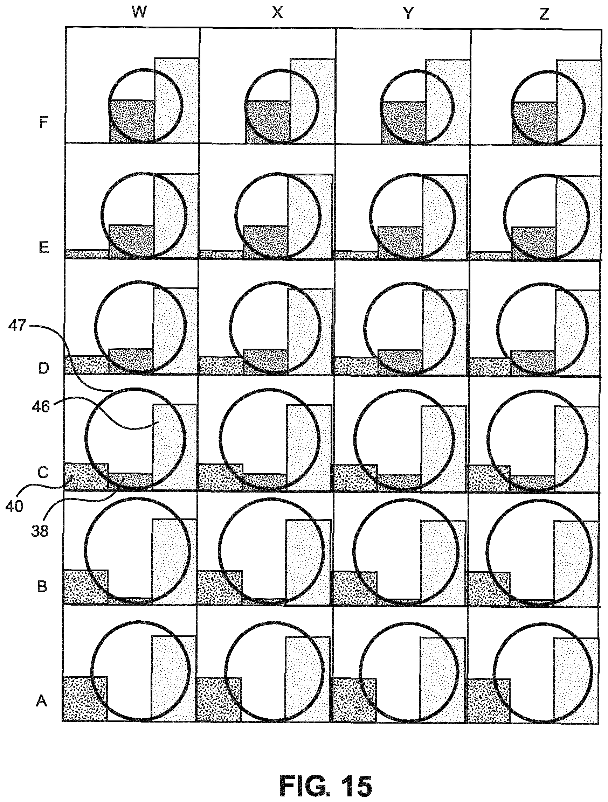

FIG. 15 illustrates a visual representation of the fluids in wells of a well plate using bar graphs 38, 40 and 46 and relative volume circles 47. The bar graph 46, representing the largest volume of fluid, is used to scale the other fluids in order to provide a good comparison of fluid volumes in each well. Only a small portion of the well plate 32 is represented by the visual display in FIG. 15 providing a visual display of the fluid in the wells in rows A-E and in columns W-Z. The amount of each fluid dispensed may vary by row, by column, or by individual cell. The digital dispense device may be programmed by use of the digital display device to deposit predetermined amounts of fluids in predetermined locations of a well plate 32 or slide 28.

It will be appreciated that the visual representations described above may be used provide the same information for applications using glass slides and spotting of liquid on the glass slides. In the glass slide application, a fluid is dispensed onto a planar substrate rather than into segregated wells. The foregoing digital representations give a user the ability to use the same digital dispense device and interface to eject fluid into wells or onto slides.

It is noted that, as used in this specification and the appended claims, the singular forms "a," "an," and "the," include plural referents unless expressly and unequivocally limited to one referent. As used herein, the term "include" and its grammatical variants are intended to be non-limiting, such that recitation of items in a list is not to the exclusion of other like items that can be substituted or added to the listed items

For the purposes of this specification and appended claims, unless otherwise indicated, all numbers expressing quantities, percentages or proportions, and other numerical values used in the specification and claims, are to be understood as being modified in all instances by the term "about." Accordingly, unless indicated to the contrary, the numerical parameters set forth in the following specification and attached claims are approximations that can vary depending upon the desired properties sought to be obtained by the present disclosure.

**Claims**

1. A digital dispense system (10) for preparing and analyzing samples, comprising

   a fluid droplet ejection system housed in a compact housing unit, the fluid droplet ejection system including:

      a fluid droplet ejection head and fluid cartridge (14) containing one or more fluids to be dispensed,
      a cartridge translation mechanism (16) for moving the fluid droplet ejection head and fluid cartridge (14) back and forth over a sample holder (32) in an x direction;
      a sample holder translation mechanism for moving a sample back and forth beneath the fluid droplet ejection head and fluid cartridge (14) in a y direction orthogonal to the x direction; and

   a digital display device (27) attached to the fluid droplet ejection system for displaying fluid volume information to a user,
   the digital dispense system (10) being **characterized in that** the fluid volume information is selected from the group consisting of relative fluid volume, absolute fluid volume, and a combination of relative and absolute fluid volumes;
   wherein
   the relative fluid volume is used to provide a relative volume display that uses one fluid with the highest volume as a maximum and scales the rest of the fluids to the fluid with the highest volume;
   wherein
   the absolute fluid volume represents an absolute dispensed fluid volume of the one or more fluids, wherein the digital display device (27) comprises a relative volume graphic for each fluid dispensed to a well in a well plate or to a slide location on a slide.

2. The digital dispense system (10) of claim 1, wherein the fluid volume information is displayed by a bar graph representation of fluid in a particular location on the slide or fluid in the well of the well plate.

3. The digital dispense system (10) of claim 1, wherein the digital display device (27) comprises an absolute volume graphic of fluid dispensed and the relative volume graphic for each fluid dispensed to the well in the well plate or to the slide location on the slide.

4. The digital dispense system (10) of claim 1, wherein the fluid droplet ejection system further comprises a processor and a memory for storing fluid droplet information and for transferring the fluid droplet information to the digital display device (27).

5. The digital dispense system (10) of claim 1, wherein the digital display device (27) comprises a portable or laptop computer.

6. A method for staining slides without dipping or immersing slides in a dye, comprising:

providing a digital fluid droplet ejection system housed in a compact housing unit, the fluid droplet ejection system including:

a fluid droplet ejection head and fluid cartridge (14) containing one or more fluids to be dispensed, a cartridge translation mechanism for moving the fluid droplet ejection head and fluid cartridge (14) back and forth over a slide holder (32) in an x direction, a slide holder translation mechanism for moving one or more slides back and forth beneath the fluid droplet ejection head and fluid cartridge (14) in a y direction orthogonal to the x direction; and

attaching a digital display device (27) to the digital fluid droplet ejection system; ejecting fluid from the fluid droplet ejection head and fluid cartridge (14) in one or more locations on the slide; and displaying fluid volume information to a user on the digital display device (27), the method being **characterized in that** the fluid volume information is selected from the group consisting of relative fluid volume, absolute fluid volume, and a combination of relative and absolute fluid volumes; wherein the relative fluid volume is used to provide a relative volume display that uses one fluid with the highest volume as a maximum and scales the rest of the fluids to the fluid with the highest volume; wherein the absolute fluid volume represents an absolute dispensed fluid volume of the one or more fluids, wherein the digital display device (27) comprises a relative volume graphic for each fluid dispensed to a well in a well plate or to a slide location on a slide.

7. The method of claim 6, further comprising ejecting two or more fluids on the slides simultaneously.

8. The method of claim 6, further comprising ejecting two or more fluids on the slides sequentially.

9. The method of claim 6, wherein the fluid volume information is displayed by a bar graph representation of fluid in a particular location on the slide or fluid in the well of the well plate.

10. The method of claim 6, wherein the digital display devices (27) comprises an absolute volume graphic of fluid dispensed and the relative volume graphic for each fluid dispensed to the well in the well plate or to the slide location on the slide.

11. The method of claim 6, wherein the fluid droplet ejection system comprises a processor and a memory, further comprising storing fluid droplet information in the memory and transferring the fluid droplet information to the digital display device (27) via the processor.

12. The method of claim 6, wherein the digital display device (27) comprises a portable or laptop computer.

**Patentansprüche**

1. Digitales Dosiersystem (10) zur Vorbereitung und Analyse von Proben, umfassend

ein Fluidtröpfchenausstoßsystem, das in einer kompakten Gehäuseeinheit untergebracht ist, wobei das Fluidtröpfchenausstoßsystem enthält:

einem Fluidtröpfchenausstoßkopf und einer Fluidkartusche (14), die ein oder mehrere zu dosierende Fluide enthält, einen Kartuschenverschiebungsmechanismus (16) zum Hin- und Herbewegen des Fluidtröpfchenausstoßkopfes und der Fluidkartusche (14) über einen Probenhalter (32) in einer x-Richtung; einen Probenhalterverschiebungsmechanismus zum Hin- und Herbewegen einer Probe unter dem Fluidtröpfchenausstoßkopf und der Fluidkartusche (14) in einer y-Richtung orthogonal zur x-Richtung; und

eine digitale Anzeigevorrichtung (27), die an dem Fluidströpfchenausstoßsystem angebracht ist, um einem Benutzer Informationen über das Fluidvolumen anzuzeigen, wobei das digitale Abgabesystem (10) **dadurch gekennzeichnet ist, dass**
die Informationen über das Fluidvolumen aus der Gruppe ausgewählt sind, die aus dem relativen Fluidvolumen, dem absoluten Fluidvolumen und einer Kombination aus relativem und absolutem Fluidvolumen besteht; wobei
das relative Fluidvolumen verwendet wird, um eine Anzeige des relativen Volumens zu liefern, die eine Fluid mit dem höchsten Volumen als Maximum verwendet und den Rest der Fluide auf das Fluid mit dem höchsten Volumen skaliert; wobei
das absolute Fluidvolumen ein absolutes dosiertes Fluidvolumen der einen oder mehreren Fluide darstellt, wobei die digitale Anzeigevorrichtung (27) eine relative Volumengrafik für jedes in eine Vertiefung in einer Vertiefungsplatte oder in eine Trägerposition auf einem Träger abgegebene Fluid umfasst.

2. Digitales Dosiersystem (10) gemäß Anspruch 1, wobei die Informationen über das Fluidvolumen durch eine Balkendarstellung von Fluid an einer bestimmten Position auf dem Träger oder von Fluid in der Vertiefung der Vertiefungsplatte angezeigt wird.

3. Digitales Dosiersystem (10) gemäß Anspruch 1, wobei die digitale Anzeigevorrichtung (27) eine Grafik des absoluten Volumens von dosierten Fluid und die Grafik des relativen Volumens für jedes Fluid umfasst, das in die Vertiefung in der Vertiefungsplatte oder an die Trägerposition auf dem Träger dosiert wurde.

4. Digitales Dosiersystem (10) gemäß Anspruch 1, wobei das Fluidtröpfchenausstoßsystem ferner einen Prozessor und einen Speicher zum Speichern von Fluidtröpfcheninformationen und zum Übertragen der Fluidtröpfcheninformationen an die digitale Anzeigevorrichtung (27) umfasst.

5. Digitales Dosiersystem (10) gemäß Anspruch 1, wobei die digitale Anzeigevorrichtung (27) einen tragbaren Computer oder Laptop umfasst.

6. Verfahren zum Färben von Trägern ohne Eintauchen oder Tränken in einen Farbstoff, umfassend:

Bereitstellen eines digitalen Fluidtröpfchenausstoßsystems, das in einer kompakten Gehäuseeinheit untergebracht ist, wobei das Fluidtröpfchenausstoßsystem enthält:

einen Fluidtröpfchenausstoßkopf und eine Fluidkartusche (14), die ein oder mehrere zu dosierende Fluide enthält,
einen Kartuschenverschiebungsmechanismus (16) zum Hin- und Herbewegen des Fluidtröpfchenausstoßkopfes und der Fluidkartusche (14) über einen Trägerhalter (32) in einer x-Richtung;
einen Trägerhalterverschiebungsmechanismus zum Hin- und Herbewegen einer oder mehrerer Träger unter dem Fluidtröpfchenausstoßkopf und der Fluidkartusche (14) in einer y-Richtung orthogonal zur x-Richtung; und

Anbringen einer digitalen Anzeigevorrichtung (27) an das digitale Fluidtröpfchenausstoßsystem;
Ausstoßen von Fluid aus dem Fluidströpfchenausstoßkopf und der Fluidkartusche (14) an einer oder mehreren Stellen auf dem Träger; und
Anzeigen von Fluidvolumeninformationen für einen Benutzer auf der digitalen Anzeigevorrichtung (27), wobei das Verfahren **dadurch gekennzeichnet ist, dass**
die Fluidvolumeninformationen aus der Gruppe ausgewählt sind, bestehend aus relativem Fluidvolumen, absolutem Fluidvolumen und einer Kombination aus relativem und absolutem Fluidvolumen; wobei
das relative Fluidvolumen verwendet wird, um eine Anzeige des relativen Volumens bereitzustellen, die eine Fluid mit dem höchsten Volumen als Maximum verwendet und den Rest der Fluide auf das Fluid mit dem höchsten Volumen skaliert; wobei
das absolute Fluidvolumen ein absolutes dosiertes Fluidvolumen der einen oder mehreren Fluide darstellt, wobei die digitale Anzeigevorrichtung (27) eine Grafik des relativen Volumens für jedes Fluid umfasst, das in eine Vertiefung einer oder in eine Trägerposition auf einem Träger abgegeben wird.

7. Verfahren gemäß Anspruch 6 ferner umfassend das gleichzeitige Ausstoßen von zwei oder mehr Fluiden auf den Träger.

8. Verfahren gemäß Anspruch 6, ferner umfassend das aufeinanderfolgende Ausstoßen von zwei oder mehr Fluiden auf den Träger.

9. Verfahren gemäß Anspruch 6, wobei die Information über das Fluidvolumen durch eine Balkendiagramm-Darstellung von Fluid an einer bestimmten Position auf dem Träger oder von Fluid in der Vertiefung der Vertiefungsplatte angezeigt wird.

10. Verfahren gemäß Anspruch 6, wobei die digitalen Anzeigevorrichtungen (27) eine Grafik des absoluten Volumens von dosiertem Fluid und die Grafik des relativen Volumens für jedes in die Vertiefung in der Vertiefungsplatte oder an die Trägerposition auf dem Träger abgegebene Fluid umfassen.

11. Verfahren gemäß Anspruch 6, wobei das Fluidtröpfchenausstoßsystem einen Prozessor und einen Speicher umfasst, ferner umfassend das Speichern von Fluidtröpfcheninformationen in dem Speicher und das Übertragen der Fluidtröpfcheninformationen an die digitale Anzeigevorrichtung (27) über den Prozessor.

12. Verfahren gemäß Anspruch 6, wobei die digitale Anzeigevorrichtung (27) einen tragbaren Computer oder Laptop umfasst.

**Revendications**

1. Un système (10) de distribution numérique pour préparer et analyser des échantillons, comprenant

   un système d'éjection de gouttelettes de fluide logé dans une unité de boîtier compacte, le système d'éjection de gouttelettes de fluide comprenant :

      une tête d'éjection de gouttelettes de fluide et une cartouche de fluide (14) contenant un ou plusieurs fluides à distribuer,
      un mécanisme (16) de translation de cartouche pour déplacer la tête d'éjection de gouttelettes de fluide et la cartouche de fluide (14) d'avant en arrière sur un support d'échantillon (32) dans une direction x ;
      un mécanisme de translation de porte-échantillon pour déplacer un échantillon d'avant en arrière sous la tête d'éjection de gouttelettes de fluide et la cartouche de fluide (14) dans une direction y orthogonale à la direction x ; et

   un dispositif (27) d'affichage numérique fixé au système d'éjection de gouttelettes de fluide pour afficher des informations sur le volume de fluide à un utilisateur,
   le système (10) de distribution numérique étant **caractérisé en ce que** les informations sur le volume de fluide sont sélectionnées dans le groupe constitué du volume de fluide relatif, du volume de fluide absolu et d'une combinaison de volumes de fluide relatifs et absolus ;
   le volume relatif de fluide est utilisé pour fournir un affichage de volume relatif qui utilise un fluide ayant le volume le plus élevé comme maximum et adapte le reste des fluides au fluide ayant le volume le plus élevé ;
   le volume de fluide absolu représente un volume de fluide distribué absolu du ou des fluides,
   le dispositif (27) d'affichage numérique comprenant un graphique de volume relatif pour chaque fluide distribué vers un puits dans une plaque à puits ou vers un emplacement de lame sur une lame.

2. Le système (10) de distribution numérique selon la revendication 1, dans lequel les informations sur le volume de fluide sont affichées par une représentation graphique à barres du fluide dans un emplacement particulier sur la lame ou du fluide dans le puits de la plaque à puits.

3. Le système (10) de distribution numérique selon la revendication 1, dans lequel le dispositif (27) d'affichage numérique comprend un graphique de volume absolu de fluide distribué et le graphique de volume relatif pour chaque fluide distribué dans le puits de la plaque à puits ou vers l'emplacement de la lame sur la lame.

4. Le système (10) de distribution numérique selon la revendication 1, dans lequel le système d'éjection de gouttelettes de fluide comprend en outre un processeur et une mémoire pour stocker des informations sur les gouttelettes de fluide et pour transférer les informations sur les gouttelettes de fluide au dispositif (27) d'affichage numérique.

5. Le système (10) de distribution numérique selon la revendication 1, dans lequel le dispositif (27) d'affichage numérique comprend un ordinateur portable ou de type laptop.

6.  Un procédé pour colorer des lames sans tremper ou immerger les lames dans un colorant, comprenant :

    le fait de prévoir un système numérique d'éjection de gouttelettes de fluide logé dans un boîtier compact, le système d'éjection de gouttelettes de fluide comprenant :

    une tête d'éjection de gouttelettes de fluide et une cartouche de fluide (14) contenant un ou plusieurs fluides à distribuer,
    un mécanisme de translation de cartouche pour déplacer la tête d'éjection de gouttelettes de fluide et la cartouche de fluide (14) d'avant en arrière sur un support coulissant (32) dans une direction x,
    un mécanisme de translation de support de lame pour déplacer une ou plusieurs lames d'avant en arrière sous la tête d'éjection de gouttelettes de fluide et la cartouche de fluide (14) dans une direction y orthogonale à la direction x ; et

    le fait de fixer un dispositif (27) d'affichage numérique au système numérique d'éjection de gouttelettes de fluide ;
    le fait d'éjecter du fluide depuis la tête d'éjection de gouttelettes de fluide et la cartouche de fluide (14) en un ou plusieurs emplacements sur la lame ; et
    le fait d'afficher une information de volume de fluide à un utilisateur sur le dispositif (27) d'affichage numérique, le procédé étant **caractérisé en ce que**
    les informations sur le volume de fluide sont sélectionnées dans le groupe constitué d'un volume de fluide relatif, d'un volume de fluide absolu et d'une combinaison de volumes de fluide relatifs et absolus ;
    le volume relatif de fluide est utilisé pour fournir un affichage de volume relatif qui utilise un fluide ayant le volume le plus élevé comme maximum et adapte le reste des fluides au fluide ayant le volume le plus élevé ;
    le volume de fluide absolu représente un volume de fluide distribué absolu du ou des fluides, le dispositif (27) d'affichage numérique comprenant un graphique de volume relatif pour chaque fluide distribué à un puits dans une plaque à puits ou à un emplacement de lame sur une lame.

7.  Le procédé selon la revendication 6, comprenant en outre le fait d'éjecter simultanément deux ou plusieurs fluides sur les lames.

8.  Le procédé selon la revendication 6, comprenant en outre le fait d'éjecter deux ou plusieurs fluides sur les lames de manière séquentielle.

9.  Le procédé selon la revendication 6, dans lequel les informations sur le volume de fluide sont affichées par une représentation graphique à barres du fluide dans un emplacement particulier sur la lame ou du fluide dans le puits de la plaque à puits.

10. Le procédé selon la revendication 6, dans lequel les dispositifs d'affichage numérique (27) comprennent un graphique de volume absolu du fluide distribué et le graphique de volume relatif pour chaque fluide distribué au puits dans la plaque à puits ou à l'emplacement de la lame sur la lame.

11. Le procédé selon la revendication 6, dans lequel le système d'éjection de gouttelettes de fluide comprend un processeur et une mémoire, comprenant en outre le fait de stocker des informations sur les gouttelettes de fluide dans la mémoire et de transférer les informations sur les gouttelettes de fluide au dispositif (27) d'affichage numérique via le processeur.

12. Le procédé selon la revendication 6, dans lequel le dispositif (27) d'affichage numérique comprend un ordinateur portable ou de type laptop.

**FIG. 1**

**FIG. 2**

**FIG. 3**

**FIG. 4**

**FIG. 5**

**FIG. 6**

**FIG. 7**

FLUID 1          FLUID 2                                    FLUID N

**FIG. 8**

PASS 1          PASS 2          PASS 3          PASS 4

**FIG. 9**

**FIG. 10A**

**FIG. 10B**

**FIG. 11A**

**FIG. 11B**

FIG. 12A

FIG. 12B

**FIG. 13**

**FIG. 14**

**FIG. 15**

**EP 3 677 917 B1**

**Patent documents cited in the description**

- US 62788290 B
- US 7909424 B2